(19) Europäisches Patentamt / European Patent Office / Office européen des brevets

(11) **EP 3 913 612 A1**

(12) **EUROPEAN PATENT APPLICATION**

(43) Date of publication:
**24.11.2021 Bulletin 2021/47**

(51) Int Cl.:
*G09G 3/32* (2016.01)  *G09G 3/36* (2006.01)
*H01L 27/32* (2006.01)

(21) Application number: **20175246.6**

(22) Date of filing: **18.05.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Vestel Elektronik Sanayi ve Ticaret A.S. 45030 Manisa (TR)**

(72) Inventor: **KURALAY,, Fatih**
**45030 Manisa (TR)**

(74) Representative: **Flint, Adam**
**Page White & Farrer**
**Bedford House**
**John Street**
**London WC1N 2BF (GB)**

(54) **DUAL FACE DISPLAY DEVICE**

(57) A dual face display device (100) has a first face (200) and a second face (300). The first face (200) and the second face (300) are angled relative to the rear plane (150) of the dual face display device (100) at a first angle (α) and a second angle (β), respectively. A single first display element (210) is located on the first face (200) and a single second display element (310) is located on the second face (300). The first face (200) and second face (300) are constructed and arranged such that light output by the first display element (210) is presented from the first face (200) to be viewed by a first user (402) from a first direction, and light output by the second display element (310) is presented from the second face (300) to be viewed by a second user (403) from a second direction different from the first direction.

Figure 1a

**Description**

Technical Field

The present disclosure relates to a dual face display device.

Background

A "display element", sometimes referred to as a "display cell" or "display pixel", is an individual element of a display screen. Each display element is only capable of outputting one light output at a time, e.g. having a specific brightness and hue or colour. However, a display screen may comprise thousands or even millions of display elements. By individually controlling the display elements, the display screen can be used to display images.

Some types of display element comprise a plurality of sub-display elements (sometimes referred to as "sub-pixels") for generating respective colour channels of the image. However, the sub-display elements are sufficiently small and/or installed sufficiently far away that a human viewer does not perceive the individual sub-display elements.

Summary

According to a first aspect disclosed herein, there is provided a dual face display device having a first face and a second face, wherein the first face is angled relative to a rear plane of the dual face display device at a first angle and the second face is angled relative to the rear plane of the dual face display device at a second angle, the dual face display device comprising: a single first display element located on the first face for outputting light corresponding to a single image pixel of a first image; and a single second display element located on the second face for outputting light corresponding to a single image pixel of a second image; wherein the first face and second face are constructed and arranged such that light output by the first display element is presented from the first face to be viewed by a first user from a first direction, and light output by the second display element is presented from the second face to be viewed by a second user from a second direction different from the first direction.

The dual face display device can be used as a unit or building block in a display screen which uses a plurality of such dual face display devices. In use, different images can be presented to different viewers who are viewing the first and second faces respectively.

In an example, the first face and the second face are perpendicular to one another.

In an example, the first angle is equal to the second angle.

In an example, at least one of the first display element and the second display element comprises a plurality of sub-display elements for providing a respective colour component.

In an example, at least one of the first display element and the second display element comprises a red sub-display element, a green sub-display element, and a blue sub-display element.

One or more of the display elements may be an LED display element, optionally comprising LED sub-display elements. The LEDs may be arranged in a common anode arrangement or in a common cathode arrangement.

One or more of the display elements may be an OLED display element.

One or more of the display elements may be an LCD display element.

According to a second aspect disclosed herein, there is provided a display screen comprising a plurality of dual face display devices of the first aspect arranged in a plane with the first faces and second faces of each of the dual face display devices being respectively aligned such that the first display elements of each of the dual face display devices output light to the same first direction and the second display elements of each of the dual face display device outputs light to the same second direction.

In an example, the display screen comprises a transparent protective coating over the display element on each face.

The transparent protective coating may be for example an epoxy coating.

In an example, the first angle and the second angle of the faces of the dual face display devices vary across the surface of the display screen from a first side corresponding to the first location to a second side corresponding to the second location.

In an example, the first angle and second angle for a particular dual face display device on the display screen are chosen such that the first face is parallel to the second direction and the second face is parallel to the first direction.

According to a third aspect disclosed herein, there is provided a method of operating a display screen as described above, the method comprising: driving the dual face display devices of the display screen such that a first image is presented from the first faces of the dual face display devices to be viewed by a first user from a first direction, and such that a second, different image is presented from the second faces of the dual face display devices to be viewed by a second user from a second direction different from the first direction.

Brief Description of the Drawings

To assist understanding of the present disclosure and to show how embodiments may be put into effect, reference is made by way of example to the accompanying drawings in which:

Figures 1a and 1b show schematically perspective views of a first example dual face display device;

Figures 2a and 2b show schematically perspective views of a second example dual face display device;

Figure 3 shows schematically an example dual face display device comprising a plurality of LEDs arranged in a common anode arrangement;

Figure 4 shows schematically an example dual face display device comprising a plurality of LEDs arranged in a common cathode arrangement;

Figure 5 shows schematically a first example display screen;

Figure 6 shows schematically a second example display screen;

Figure 7 shows schematically an example display screen comprising a transparent coating;

Figure 8 shows schematically the display screen being used to display two images simultaneously;

Figure 9a shows schematically a first example application of the display screen;

Figure 9b shows schematically a second example application of the display screen;

Figure 10 shows schematically an example of a display screen;

Figure 11 shows schematically an example of how the construction of a particular display device within a display screen can be determined; and

Figure 12 shows an alternative example of a display device.

Detailed Description

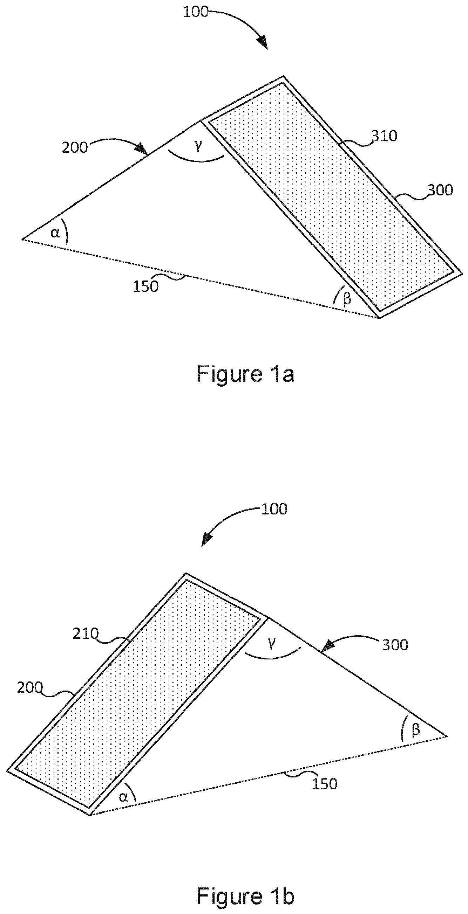

Figures 1a and 1b show schematically different perspective views of an example dual face display device 100 (often simply referred to herein as "display device 100").

The display device 100 has a first face 200 and a second face 300. The first face 200 and second face 300 are planar (i.e. flat). A first display element 210 is located on the first face 200 and a second display element 310 is located on the second face 300. This is returned to later below.

The first face 200 and the second face 300 are arranged such that light output by the first display element 210 is presented from the first face 200 to be viewed by a first user at a first location and light output by the second display element 310 is presented from the second face 300 to be viewed by a second user at a second location different from the first location. As such, a display screen formed of a plurality of display devices 100 is able to present a first image to the first user at the first location and a second, potentially different, image to the second user at the second location.

In this example, the first face 200 and the second face 300 are each rectangular. As shown in Figures 1a and 1b, the first face 200 and the second face 300 meet at an angle γ along an upper edge. The angle γ, at which the first face 200 and the second face 300 meet is less than 180°.

As shown in Figures 1a and 1b, a rear plane 150 is defined by the bottom edge of the first face 200 (opposite the upper edge of the first face 200, where the first face 200 meets the second face 300) and the bottom edge of the second face 300 (opposite the upper edge of the second face 300, where the second face 300 meets the first face 200). In this arrangement, the first face 200 and the second face 300 form two sides of a triangular prism shape, the third side being a portion of the the rear plane 150. The first face 200 intersects the rear plane 150 at a first angle α. The second face 300 intersects the rear plane 150 at a second angle β. The display device 100 may or may not comprise a physical third face corresponding to the rear plane 150, i.e. a "rear" face opposite the upper angle γ. If present, such a rear face can provide additional structural integrity to the display device 100. It may also allow for easier mounting of a plurality of display devices 100 into a display screen 1000 (described below). Alternatively, there may be no physical rear face. This may allow easy access to the rear of the first display element 210 and second display element 310. This may be used for example to provide control and power circuitry to the first display element 210 and second display element 310.

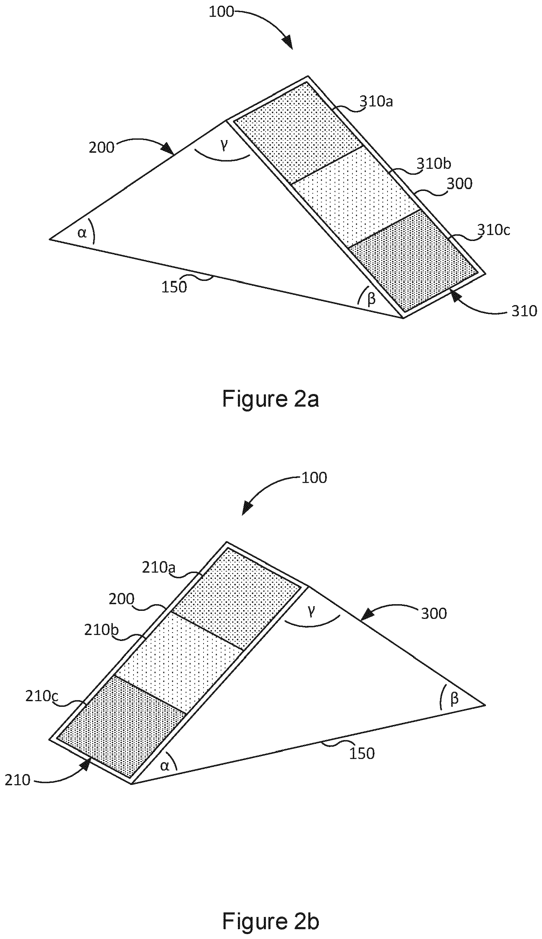

The first display element 210 and second display element 310 are what is often referred to as "pixels", "display pixels" or "display cells" or the like. Light generated by the first display element 210 and second display element 310 is output from the front of the display device 100 (shown at the top in Figures 1a and 2b). As described in more detail below, a display screen formed of a plurality of display devices 100 is capable of displaying both a first image (using the first display elements 210) and a second image (using the second display elements 310). Hence, the front of the display device 100 may be referred to as the "image-forming side".

Each display element may comprise a plurality of sub-display elements, often correspondingly referred to as "sub-pixels" or "sub-display cells" or the like. An example is shown in Figures 2a and 2b in which the first display element 210 comprises three sub-display elements 210a-c and the second display element 310 comprises three sub-display elements 310a-c. The construction of the display device 100 is otherwise the same as that described above in relation to Figures 1a and 1b.

In this case, each of the sub-display elements, when active, may emit light having a different colour. For example, the first display element 210 may be an RGB (red-green-blue) display element in which the sub-display elements comprise a red sub-display element for emitting red light, a green sub-display element for emitting green light, and a blue sub-display element for emitting blue light. Similar considerations apply in relation to the second display element 310.

In an example, each sub-display element provides a different respective colour component (such as RGB respectively). In other examples, the display elements may comprise four or more sub-display elements. For example, one or more of the display elements may comprise one or more additional sub-display elements, e.g. a yellow sub-display element for emitting yellow light, a cyan sub-display element for emitting cyan light, a white sub-display element for emitting white light, etc. One or more of the display elements may comprise two or more sub-display elements of the same type. For example, an RGB display element may comprise a second, or even third, red, green, or blue sub-display element (in addition to the normal one of each red, green and blue sub-display element). This can assist in allowing that display element to achieve a specific target colour temperature or brightness.

Various types of display element ("display pixel", "display cell") are known in the art. The display device 100 may be implemented using any type of display element. Examples of display elements include LCDs (liquid crystal displays), LEDs (light emitting diodes), plasma cells for plasma display panels, ELDs (electroluminescent displays), OLEDs (organic light emitting diodes), QLED (quantum dot LED), etc.

In some examples, such as illustrated in Figures 2a and 2b, the first display element 210 and the second display element 310 may be substantially the same (or at least be of the same type). This has the advantage of simplifying manufacture of the display device 100.

In other examples, the first display element 210 and the second display element 310 may be different (e.g. different types). In some example, the first display element 210 and the second display element 310 may comprise different numbers of sub-display elements from each other. In some examples, the first display element 210 and the second display element 310 may or may not have the same number and/or type (colour) of sub-display elements.

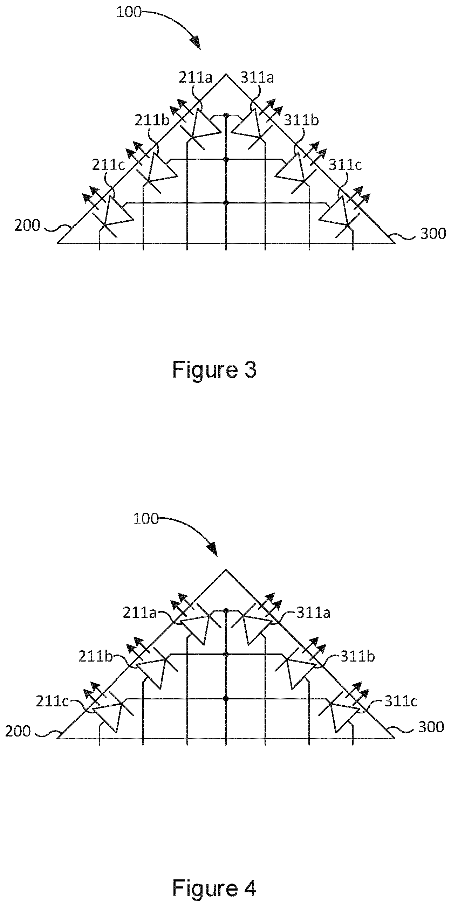

Figure 3 shows schematically a specific example of a display device 100. In this example, the first display element 210 is an RGB LED display element comprising three LEDs 211a-c and the second display element 310 is also an RGB LED display element comprising three LEDs 311a-c. The display device 100 thereby comprises six LEDs in total.

In this example, the LEDs are arranged in a "common anode" configuration. In this configuration, all six LEDs share a power line (anode). Each individual LED is controllable by selectively controlling the output (cathode) of each LED.

Figure 4 shows schematically a second specific example of a display device 100 which is substantially the same as the first example except that the LEDs are arranged in a "common cathode" configuration. In this configuration, all six LEDs share a sink (cathode). Each individual LED is controllable by selectively controlling the input (anode) of each LED.

Whatever the specific type of display elements used, a plurality of display devices 100 can be arranged together to form a display screen, as mentioned above. The display devices 100 effectively form base units or cells which can be assembled to provide the image-forming part of the display screen. For example, a printed circuit board (PCB) may be provided which corresponds to the rear plane 150 described above. The display devices 100 may be mounted to this PCB using surface mount technology (SMT) to form the PCB assembly (PCBA). The display devices 100 may therefore be referred to as "packages", e.g. LED packages, which can be arranged to form a display screen. The individual display devices 100 do not have to all be the same type of display device, but this does have the advantage of simplifying the manufacturing process.

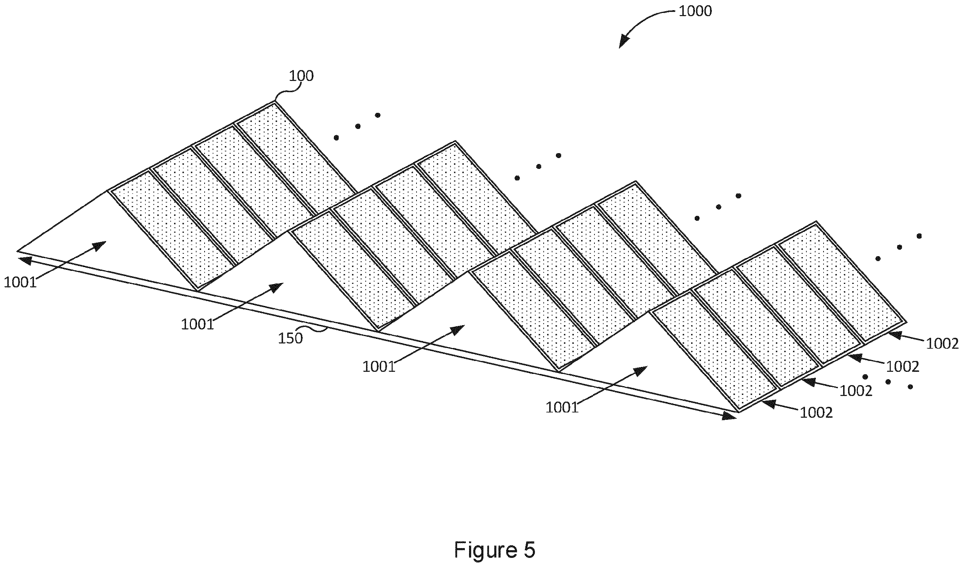

A first example of a display screen 1000 is shown schematically in Figure 5. The display screen 1000 is constructed of a plurality of display device 100 arranged in an array with a common rear plane 150. In Figure 2, sixteen display devices 100 are shown arranged in a 4x4 square array. It is appreciated the display screen 1000 may extend much further than this. For example, the display screen 1000 may comprise thousands or millions of display devices 100. In this example, the display devices 100 are arranged in a grid having rows 1001 and columns 1002. Each row 1001 comprises a plurality of display devices 100 arranged "side by side", i.e. the first faces 210 of the display devices 100 in that row 1001 are co-planar and the second faces 310 of the display devices 100 in that row 1001 are co-planar. In this example, the display devices 100 are all similar and therefore this also means that the upper edges of the display devices 100 in each row 1001 are aligned. Each column 1002 comprises a plurality of display devices 100 arranged "end to end", i.e. the first face 210 of one display device 100 in that column 1002 opposes the second face 310 of the adjacent display device in that column 1002 at the rear plane 150, etc.

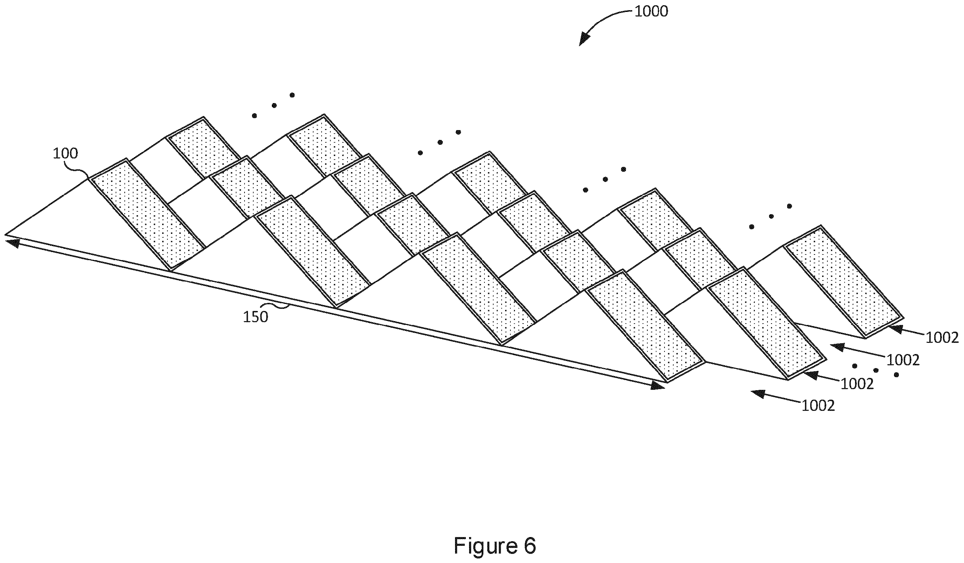

A second example of a display screen 1000 formed of a plurality of display devices 100 is shown schematically in Figure 6. Again, only a 4x4 portion of the display screen 100 is shown. In this example, the display devices 100 are again arranged in columns 1002, as in the previous example. However, each column 1002 is staggered relative to its adjacent columns 1002. That is, the upper edges of the display devices 100 in one column 1002 do not align with the upper edges of the display devices 100 in adjacent columns 1002.

It is appreciated that there may be some degree of separation between the display devices 100 disposed on the rear plane 150. That is, there may or may not be gaps between the display devices 1000 in each row 1001 or column 1002. For example, when the display devices 100 are LED packages, there may be a maximum packing density (minimum separation) for their arrangement into a display screen 1000 due to SMT limitations.

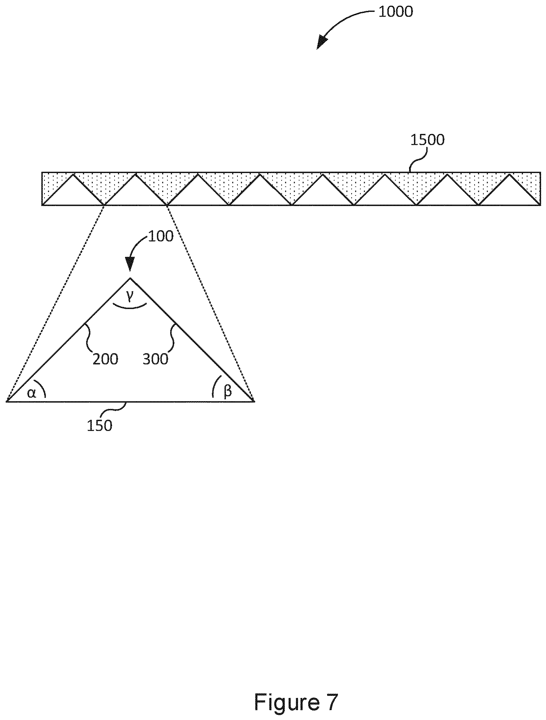

Because the display devices 100 comprise only a single display element 210, 310 on each face 200, 300, the display devices 100 can be made very small (i.e. with a small height normal to the rear plane 150). This means that a display screen 1000 formed of the display devices 100 may appear substantially flat when viewed from a distance. In some examples, a transparent coating 1500 may be applied over the display elements on each face (i.e. on the image-forming side of the display device 100) to create a flat protective surface, as illustrated in Figure 7. An example of a suitable transparent coating is an epoxy coating. The transparent coating has an advantage of forming a flat surface and also of protecting the display devices 100.

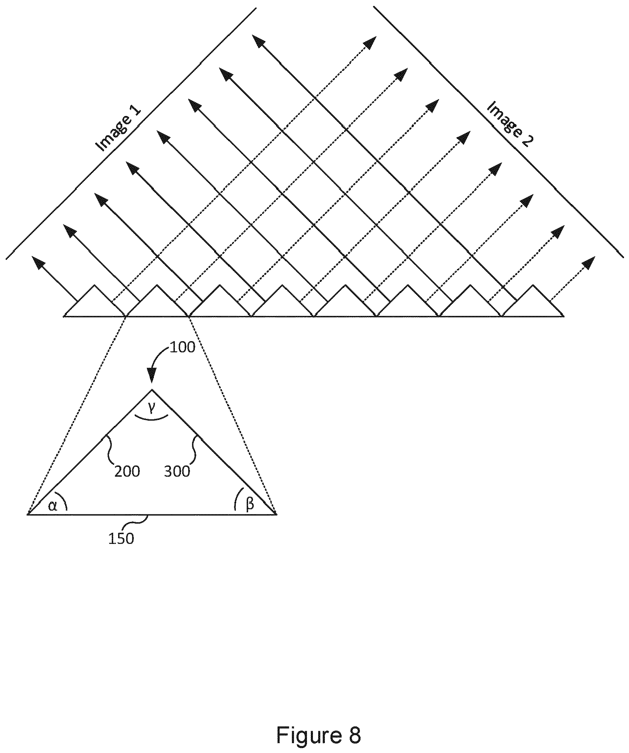

Figure 8 shows schematically how the display screen 1000 can be used to display two different images simultaneously. The first display elements 210 of each of the display devices 100 are viewable from a first direction (and substantially not from a second direction) and the second display elements 310 of each of the display devices 100 are viewable from the second direction (and substantially not from the first direction). This means that a first user looking at the display screen 1000 from the first direction will see the image pixels presented by the first display elements 210, whereas a second user looking at the display screen 1000 from the second direction will see image pixels presented by the second display elements 310. The first display elements 210 together can therefore act as a first screen for display a first image and the second display elements can act as a second screen for display a second image.

Put differently, the first faces 200 of each display device 100 form a first "composite screen" for displaying the first image and the second faces 300 of each display device 100 form a second "composite screen" for displaying the second image.

The angles at which the first and second image can be viewed by a user depend, at least in part, on the first angle $\alpha$ and second angle $\beta$ of the first and second faces 200, 300 respectively. The first and second angles may be the same for a given display device 100, as in the examples above, which has the advantage of simplifying the manufacturing process for that display device 100. As a particular example, the first angle $\alpha$ and second angle $\beta$ may each be 30°. In some examples, the first and second angles may be the same for each display device 100 in the display screen 1000. That is, each display device 100 in the display screen 1000 may be substantially the same. This has the advantage of simplifying the manufacturing process and lowering manufacturing costs of the display screen 1000.

In other examples, described further below, the first and second angles may be different. The first and second angles, while different for a particular display device 100, may be the same for each display device 100 in the display screen 1000. That is, again, each display device 100 in the display screen 1000 may be substantially the same. As above, this has the advantage of simplifying the manufacturing process and lowering manufacturing costs of the display screen 1000.

In yet further examples, the first and second angles (which may be the same or different for a particular display device 100) may be different for different display devices 100 forming different parts of the display screen 1000, as described in more detail below. This has the advantage of enabling the images to be better directed towards the viewers in some cases, as described in more detail below.

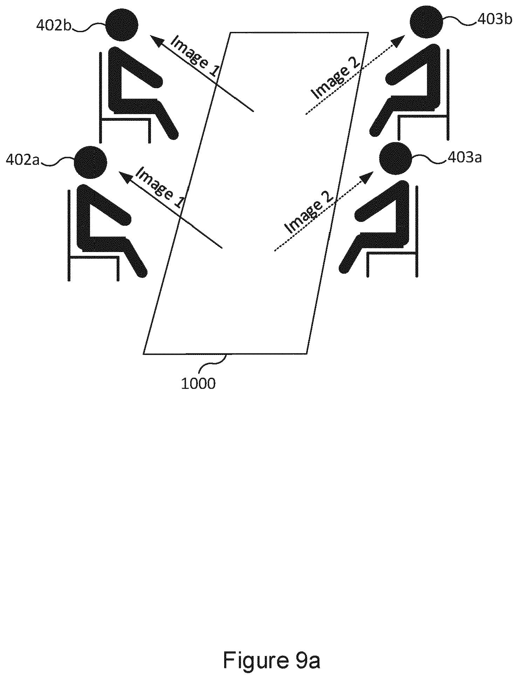

Figure 9a shows an example in which the display screen 1000 is installed at an area of floor. The floor may be, for example, the floor of a public transport carriage (e.g. an overground or an underground or metro train). In this case, the columns 1002 of the display screen 1000 run from one side of the floor to the other (left-right in Figure 9a). Users 402 on one side of the display screen 1000 will see the first image presented by the first faces 200 of the display devices 100 and users 403 on the other side of the display screen 1000 will see the second image presented by the second faces 300 of the display devices 100.

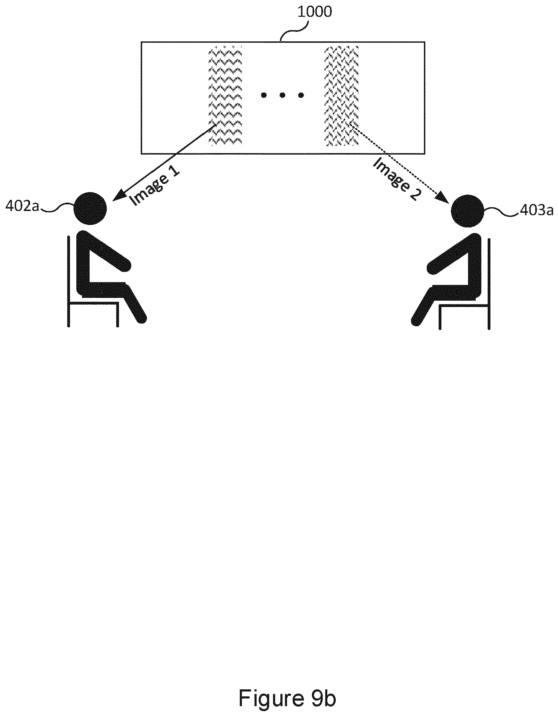

Figure 9b shows another example in which the display devices 100 is installed on a vertical surface such as a wall, e.g. the display devices 100 may form part of an LED wall module. In this case, the columns 1002 of the display screen 1000 run horizontally.

In yet further examples, the display screen 1000 may form all or part of another surface such as the top of a desk or table. For example, a display screen 1000 arranged on a table surface between two users sitting opposite each other can provide different images to each of the users.

It is appreciated that when the first face 200 and second face 300 are flat, the first angle $\alpha$, second angle $\beta$, and the third angle $\gamma$ at which the first face 200 and the second face 300 meet are constrained such that $\alpha+\beta+\gamma=180°$.

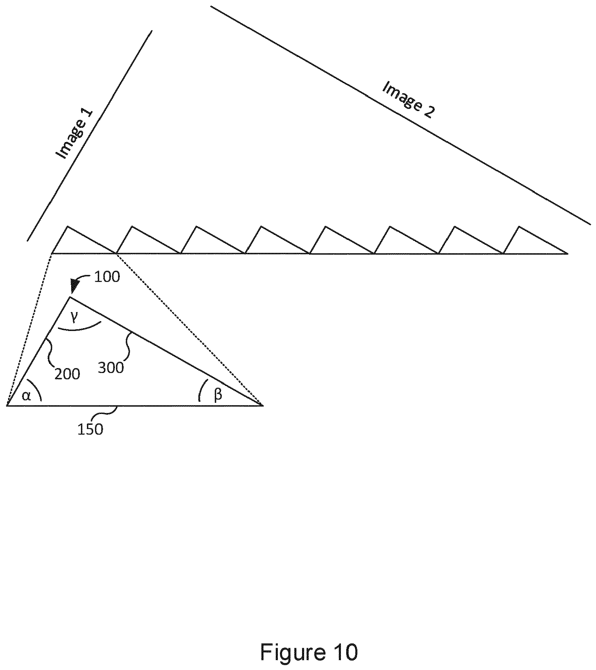

Figure 10 shows an example in which the first angle $\alpha$ is smaller than the second angle $\beta$. This means that the second image (formed by the second display elements 310) is visible from a different angle relative to the rear plane 150 than the second image (formed by the first display elements 210).

In some examples, the first angle $\alpha$ and second angle $\beta$ of the display devices 100 may vary across the surface of the display screen 1000. That is, each column 1002 may comprise a plurality of display devices 100 which are substantially the same except for the angles at which the first face 200 and second face 300 meet the rear plane 150. Specifically, in an example, the display screen 1000 can be designed to be most suitable for two predetermined viewpoints. Further, the first angles α and second angles β of the display devices 100 may vary differently for the two sets of faces 200, 300. This can be set so that the images presented by the respective sets of faces 200, 300 have different fields of view, i.e. the display devices 100 for the two sets of faces 200, 300 present their respective images over different viewing angles.

A controller may be provided for controlling the display screen 1000 to display a first and second image in accordance with first and second image data. The controller may apply some appropriate digital image processing to the original image data in order to correct the images to account for distortion caused by the varying first and second angles across the display screen 1000.

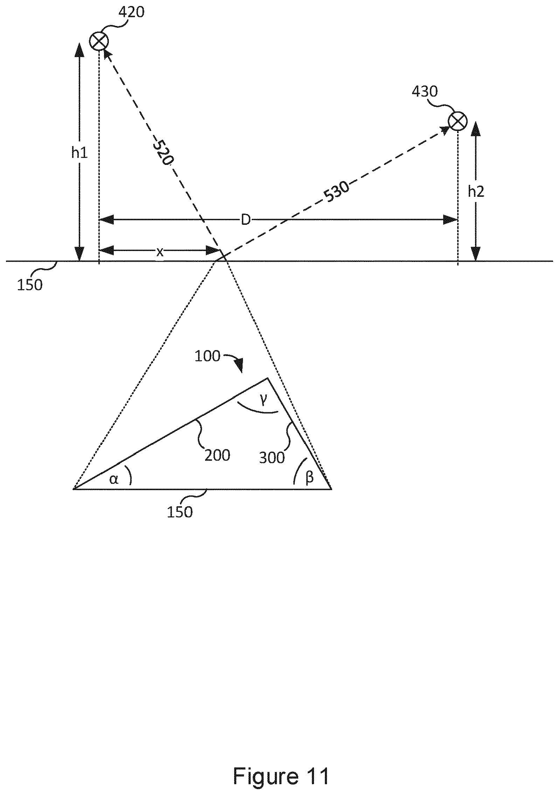

Figure 11 shows schematically one manner in which the first and second angles for a display device 100 to be mounted at a given location on a display screen 1000 may be determined.

A first viewpoint 420 and a second viewpoint 430 are shown relative to the rear plane 150. The first viewpoint 420 is located at a perpendicular height $h_1$ above the rear plane 150 and the second viewpoint 430 is located at a perpendicular height $h_2$ above the rear plane 150. The horizontal distance (parallel to the rear plane 150) between the first viewpoint 420 and the second viewpoint 430 is D.

A "test" display element 100 is shown located a distance x along the rear plane 150 from directly below the first viewpoint 420. A first direction 520 is defined as towards the first viewpoint 420 from the test display element 100. A second direction 530 is defined as towards the second viewpoint 430 from the test display element 100.

A suitable first angle α for the test display element 100 is given by:

$$\alpha = tan^{-1}(\frac{h_2}{D-x})$$

This choice of first angle ensures that the first face 200 is parallel to the second direction (i.e. the first face 200 lies on a ray originating at the second viewpoint 430). This means that a user looking at the display device 1000 from the second viewpoint 430 will not be able to see the first face 200 (and will only see the second face 300).

A suitable second angle β for the test display element 100 is given by:

$$\beta = tan^{-1}(\frac{h_1}{x})$$

This choice of second angle ensures that the second face 300 is parallel to the first direction (i.e. the second face 200 lies on a ray originating at the first viewpoint 420). This means that a user looking at the display device 1000 from the first viewpoint 420 will not be able to see the second face 300 (and will only see the first face 200).

It is noted that the dependency on x diminishes the further away from the rear plane 150 the first viewpoint 420 and second viewpoint 430 are located.

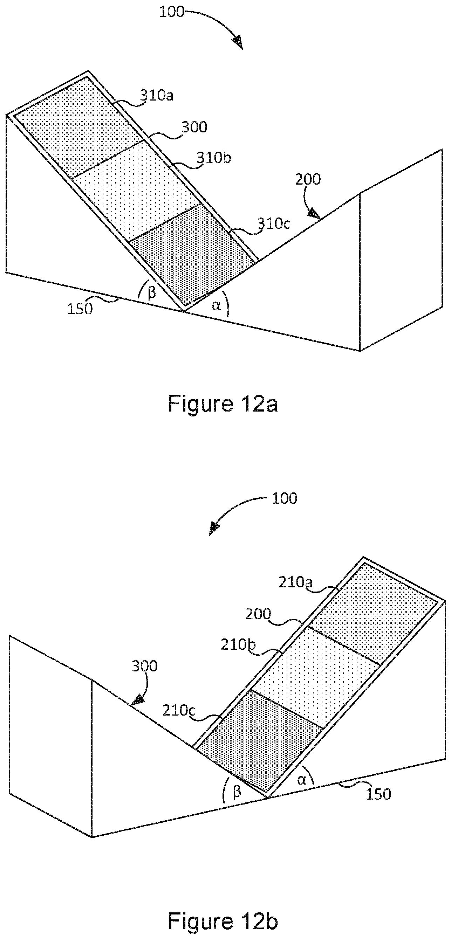

Figures 12a and 12b show an example of a display device 100 in which the first face 210 and second face 310 meet at their bottom edges along the rear plane 150 (rather than the top edges as in the example of, e. g. Figures 2a and 2b). Such display devices 100 can be incorporated into a display screen in a similar manner as described for the examples above. Further, variations as described above may also be employed, including for example the display devices 100 having the same or different angles for their faces 210, 310, same or different angles across the plurality of display devices 100 of the display screen, etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

**Claims**

1. A dual face display device (100) having a first face (200) and a second face (300), wherein the first face (200) is angled relative to a rear plane (150) of the dual face display device (100) at a first angle (α) and the second face (300) is angled relative to the rear plane (150) of the dual face display device (100) at a second angle (β), the dual face display device (100) comprising:

    a single first display element (210) located on the first face (200) for outputting light corresponding to a single image pixel of a first image; and
    a single second display element (310) located on the second face (300) for outputting light corresponding to a single image pixel of a second image;
    wherein the first face (200) and second face (300) are constructed and arranged such that light output by the first display element (210) is presented from the first face (200) to be viewed by a first user (402) from a first direction, and light output by the second display element (310) is presented from the second face (300) to be viewed by a second user (403) from a second direction different from the first direction.

2. A dual face display device (100) according to claim 1, wherein the first face (200) and the second face (300) are perpendicular to one another.

3. A dual face display device (100) according to claim 1 or claim 2, wherein the first angle ($\alpha$) is equal to the second angle ($\beta$).

4. A dual face display device (100) according to any of claims 1 to 3, wherein at least one of the first display element (210) and the second display element (310) comprises a plurality of sub-display elements (210a, 210b, 210c) for providing a respective colour component.

5. A dual face display device (100) according to claim 4, wherein at least one of the first display element (210) and the second display element (310) comprises a red sub-display element, a green sub-display element, and a blue sub-display element.

6. A display screen (1000) comprising a plurality of dual face display devices (100) according to any of claims 1 to 5 arranged in a plane with the first faces (200) and second faces (300) of each of the dual face display devices (100) being respectively aligned such that the first display elements (210) of each of the dual face display devices (100) output light to the same first direction and the second display elements (310) of each of the dual face display device (100) outputs light to the same second direction.

7. A display screen (1000) according to claim 6, comprising a transparent protective coating (1500) over the display element on each face.

8. A display screen (1000) according to claim 6 or claim 7, wherein the first angle ($\alpha$) and the second angle ($\beta$) of the faces of the dual face display devices (100) vary across the surface of the display screen (1000) from a first side corresponding to the first location to a second side corresponding to the second location.

9. A method of operating a display screen (1000) according to any of claims 6 to 8, the method comprising:
driving the dual face display devices (100) of the display screen (1000) such that a first image is presented from the first faces (200) of the dual face display devices (100) to be viewed by a first user (402) from a first direction, and such that a second, different image is presented from the second faces (300) of the dual face display devices (100) to be viewed by a second user (403) from a second direction different from the first direction.

Figure 1a

Figure 1b

Figure 2a

Figure 2b

Figure 3

Figure 4

Figure 5

Figure 6

1000

1500

100

γ

200    300

α    β

150

Figure 7

Figure 8

Figure 9a

1000

402a

Image 1

Image 2

403a

Figure 9b

Figure 10

Figure 11

Figure 12a

Figure 12b

Europäisches
Patentamt

European
Patent Office

Office européen
des brevets

# EUROPEAN SEARCH REPORT

Application Number

EP 20 17 5246

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 246 910 A1 (AU OPTRONICS CORP [TW]) 22 November 2017 (2017-11-22) * paragraphs [0012] - [0027], [0054] - [0056]; figures 1A, 1B,6 * | 1-9 | INV. G09G3/32 G09G3/36 H01L27/32 |
| A | WO 2018/190856 A1 (HEWLETT PACKARD DEVELOPMENT CO [US]) 18 October 2018 (2018-10-18) * paragraphs [0026] - [0032]; figures 3,4(a),(b) * | 1-9 | |
| A | US 2019/197928 A1 (SCHUBERT MARTIN FRIEDRICH [US] ET AL) 27 June 2019 (2019-06-27) * figure 4 * | 1-9 | |
| A | WO 2007/049213 A2 (KONINKL PHILIPS ELECTRONICS NV [NL]; KARMAN GERARDUS P [NL] ET AL.) 3 May 2007 (2007-05-03) * figures 8A-8C * | 1-9 | |
| A | US 2010/188324 A1 (OHASHI YUSUKE [JP] ET AL) 29 July 2010 (2010-07-29) * figures 3,11,15 * | 1-9 | TECHNICAL FIELDS SEARCHED (IPC) G09G H01L |

The present search report has been drawn up for all claims

| Place of search | Date of completion of the search | Examiner |
|---|---|---|
| Munich | 31 July 2020 | Demin, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

**EP 3 913 612 A1**

## ANNEX TO THE EUROPEAN SEARCH REPORT
## ON EUROPEAN PATENT APPLICATION NO.

EP 20 17 5246

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2020

| Patent document cited in search report | | | Publication date | Patent family member(s) | | | Publication date |
|---|---|---|---|---|---|---|---|
| EP | 3246910 | A1 | 22-11-2017 | CN | 106129085 | A | 16-11-2016 |
| | | | | EP | 3246910 | A1 | 22-11-2017 |
| | | | | TW | 201742242 | A | 01-12-2017 |
| | | | | US | 2017337863 | A1 | 23-11-2017 |
| WO | 2018190856 | A1 | 18-10-2018 | NONE | | | |
| US | 2019197928 | A1 | 27-06-2019 | US | 2019197928 | A1 | 27-06-2019 |
| | | | | US | 2019378445 | A1 | 12-12-2019 |
| | | | | WO | 2019125914 | A1 | 27-06-2019 |
| WO | 2007049213 | A2 | 03-05-2007 | CN | 101297414 | A | 29-10-2008 |
| | | | | EP | 1943692 | A2 | 16-07-2008 |
| | | | | JP | 5020961 | B2 | 05-09-2012 |
| | | | | JP | 2009514157 | A | 02-04-2009 |
| | | | | TW | 200739993 | A | 16-10-2007 |
| | | | | US | 2008285282 | A1 | 20-11-2008 |
| | | | | WO | 2007049213 | A2 | 03-05-2007 |
| US | 2010188324 | A1 | 29-07-2010 | CN | 101779079 | A | 14-07-2010 |
| | | | | JP | 5103286 | B2 | 19-12-2012 |
| | | | | JP | 2009099529 | A | 07-05-2009 |
| | | | | KR | 20100022037 | A | 26-02-2010 |
| | | | | TW | 200912471 | A | 16-03-2009 |
| | | | | US | 2010188324 | A1 | 29-07-2010 |

EPO FORM P0459

For more details about this annex : see Official Journal of the European Patent Office, No. 12/82